# EUROPEAN PATENT APPLICATION

(11) **EP 2 924 732 A1**
(43) Date of publication of application: **30.09.2015**
(21) Application number: 15161083.9
(22) Date of filing: 26.03.2015
(51) Int. Cl.: H01L 25/075, H01L 33/60, F21K 99/00, H05B 33/00, F21V 17/10, F21V 19/00, F21V 17/16, F21V 23/06, H01R 33/00

(54) **Easily-assembled cob lamp bead, support for the lamp bead, method for manufacturing the lamp bead, and easily-assembled led module.**

(30) Priority: 28.03.2014 CN 201410121762
(71) Applicant: MLS Co., Ltd., Xiaolan Town, ZhongShan Guangdong 528-400 (CN)
(72) Inventor: LIU, Tianming, 528400 Zhongshan City (CN); XIAO, Hu, 528400 Zhongshan City (CN); ZHOU, Bingbing, 528400 Zhongshan City (CN)
(74) Representative: Van Straaten, Joop

(57) **Abstract**

The present invention relates to the technical field of LED packaging, in particular to an easily-assembled COB lamp bead, a support for the lamp bead, a method for manufacturing the lamp bead and an easily-assembled LED module using the lamp bead (3). For the LED lamp bead provided by the present invention, as a first metal welding layer is provided on the bottom surface, it is just required to directly weld the lamp bead (3) in a heat sink (1) during assembling. Due to a power-taking slot (36) formed of a positive plate (32) and a negative plate (33) in a matched manner, it is just required to insert one end of a driving circuit board (2), having a conductive terminal, into the slot (36) during assembling. Hence, the whole assembling process is very simple, and both the efficiency and quality of assembling are effectively improved.

## Description

### FIELD OF THE INVENTION

The present invention relates to the technical field of LED packaging, in particular to an easily-assembled COB lamp bead, a support for the lamp bead, a method for manufacturing the lamp bead and an easily-assembled LED module using the lamp bead.

### BACKGROUND OF THE INVENTION

LED packaging is an important link of the production of LED lamp beads. At present, high-power LED lamp beads are generally Surface Mount Device (SMD) packaged. Although this packaging mode is relatively mature, it is required to fix wafers on a lead frame to form a separate device and then weld a plurality of separate devices onto a substrate (PCB), resulting in the disadvantages of completed process, high cost, large heat resistance and the like. In the art, it tends to develop Chip On Board (COB).

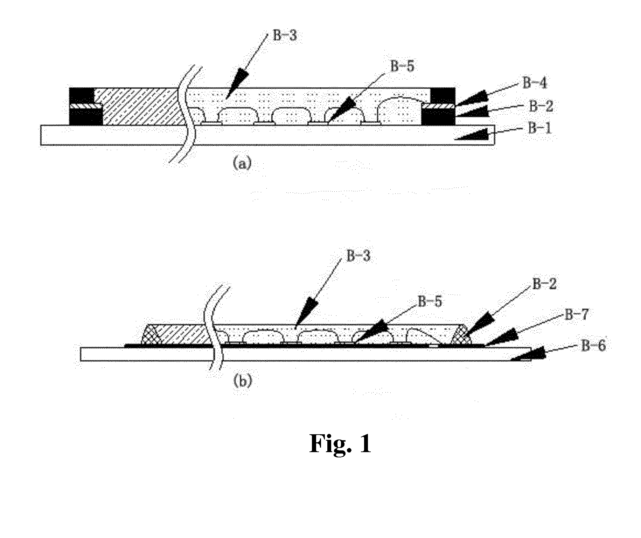

COB is to directly fix LED wafers onto a substrate (PCB) for packaging, resulting in the advantages of high productivity, low heat resistance, good optical property and the like. At present, the substrates employed by COB mainly include conductive substrates made of copper or other conductive metals and insulating substrates made of ceramics or other insulating materials. For a conductive substrate having a structure as shown in Fig. 1(a), LED wafers B-5 are directly fixed onto a copper substrate B-1, a lamp cup B-2 (enclosure) is formed of a Polyphthalamide (PPA) material on the cupper substrate and then filled with packaging glue B-3, a copper terminal B-4 is provided on the lamp cup, and the LED wafers B-5 are bonded and connected to the copper terminal B-4 for taking power. Generally, the copper terminal B-4 extends outside to be partially exposed, facilitating the copper terminal B-4 to be connected to the driving circuit. For an insulating substrate having a structure as shown in Fig. 1(b), a conductive layer B-7 is plated on a ceramic substrate B-6, LED wafers B-5 are fixed in a wafer fixing region on the conductive layer B-7 and connected together by bonding wires, and a lamp cup B-2 (enclosure) is formed around the wafer fixing region and filled with packaging glue B-3, wherein the conductive layer B-7 partially extends to the outside of the lamp cup B-2 to be exposed, facilitating the electrical connection to the driving circuit.

Therefore, a conductive region for connecting a driving circuit is exposed from the surface of each of the packaged LED beads. Meanwhile, to mount the lamp bead onto a heat sink, a fixed pore is generally further formed on the substrate. As disclosed in Patent CN102853299A, when assembling such a lamp bead, it is generally required to fix a substrate onto a heat sink first by fastening screws or other fastening elements in aid of the fixed pore, and then, weld a conductive lead in the conductive region and weld the other end of the conductive lead onto the driving circuit board. Apparently, such a structure has the following disadvantages:
the fixing operation is complicated as screws or other auxiliary fastening components are required, and ceramic substrates or other fragile substrates are very likely to be damaged during the fixation, causing high defect rate; and
the assembling efficiency is greatly reduced as the welding of the conductive leads is complicated, and it is likely to make the whole lamp unqualified due to the substandard welding at the welding points.

Therefore, the existing lamp bead structure makes the assembling process difficult, thereby causing the problems of low assembling efficiency and poor assembling quality.

### SUMMARY OF THE INVENTION

One objective of the present invention is to provide an LED lamp bead which is easy to be secured to a heat sink without any lead welding and thus to be assembled simply and which improves both the assembly efficiency and quality, in order to avoid deficiencies in the prior art.

Another objective of the present invention is to provide a support for the lamp bead and an LED module using the lamp bead, in order to avoid deficiencies in the prior art.

Yet another objective of the present invention is to provide a method for manufacturing the LED lamp bead with simple steps, saved cost and high productivity, in order to avoid deficiencies in the prior art.

The objectives of the present invention are achieved by the following technical solutions.

A support for an easily-assembled COB lamp bead is provided, including a substrate and a power-taking plate for supplying power to the substrate, wherein one surface of the substrate is plated with a first metal welding layer to form a welding surface, the power-taking plate including a positive plate and a negative plate, which are electrically conductive, the positive plate and the negative plate being insulated from and matched with each other to form a power-taking slot.

Preferably, the support is obtained by punching a conductive plate.

An easily-assembled COB lamp bead is provided, including a support onto which LED wafers are adhered on its front surface, wherein the bottom surface of the support is plated with a first metal welding layer, the support including a substrate and a power-taking plate for supplying power to the LED wafers, the power-taking plate including a positive plate and a negative plate, which are electrically conductive, the positive plate and the negative plate being insulated from and matched with each other to form a power-taking slot.

Preferably, a lamp cup is formed on the front surface of the support, the lamp cup including a cup cavity to which the substrate is exposed to form a wafer fixing region for fixing the LED wafers; and each of the positive plate and the negative plate includes a power supply region, a fixing region and a power taking region, the power supply region being exposed to the cup cavity, the fixing region is embedded on a wide wall of the lamp cup, the power taking region being exposed outside the lamp cup and forming the power-taking slot.

Preferably, a first spacer for isolating the substrate from the power-taking plate is provided in the cup cavity.

Preferably, a second spacer for isolating the positive plate from the negative plate is provided in the cup cavity.

Preferably, the first metal welding layer includes a nickel layer covering the bottom surface of the support and a silver layer covering the nickel layer.

An easily-assembled LED module is provided, including a heat sink, a lamp bead fixed in the heat sink and a driving circuit board for supplying current to the lamp bead, wherein the lamp bead is the easily-assembled lamp bead as above described; a junction surface of the heat sink with the lamp bead is plated with a second metal welding layer, the first metal welding layer and the second metal welding layer being fixed with each other by welding; and a power supply terminal is provided at one end portion of the driving circuit board, the power supply terminal being snapped in the power-taking slot to supply power to the power-taking plate.

Preferably, an inner cavity is formed in the heat sink, the driving circuit board being disposed in the inner cavity; a welding surface of the heat sink and the lamp bead is provided with a through hole; a conductive region, in which the conductive terminal is to be provided, of the driving circuit board is in interference fit with the conductive slot, the size between the two sides of the conductive region being larger than that of the power-taking slot and the length of the conductive region being equal to the depth of the power-taking slot.

Finally, a method for manufacturing an easily-assembled COB lamp bead, including the following steps of: a plate making step, an injection molding step, a wafer fixing step, a glue filling step and a separation step, wherein:
the plate making step: punching a conductive plate to form a support, the support including a substrate, a positive plate and a negative plate, the substrate, the positive plate and the negative plate being connected to the plate by connecting bars, respectively;
the injection molding step: injection-molding a lamp cup on the plate with the support punched thereon, the lamp cup including a cup cavity, the cup cavity and the substrate forming a wafer fixing region, the cup cavity, the positive plate and the negative plate forming a power supply region;
the wafer fixing step: fixing LED wafers in the wafer fixing region of the substrate, and conductively connecting the substrate to the positive plate and the negative plate, respectively;
the glue filling step: filling packaging glue in the cup cavity; and
the separation step: cutting off the connecting bars between the substrate, the positive plate and the negative plate, and the plate, to allow the lamp bead to separate from the plate.

The present invention has the following beneficial effects that. For the LED lamp bead, as a first metal welding layer is provided on the bottom surface, it is just required to directly weld the lamp bead in a heat sink during assembling; due to a power-taking slot formed of a positive plate and a negative plate in a matched mode, it is just required to insert one end of a driving circuit board, having a conductive terminal, into the slot during assembling. Hence, the whole assembling process is very simple, and both the efficiency and quality of assembling are effectively improved. For the LED lamp bead of the present invention, as a first metal welding layer is provided on the bottom surface, and due to a power-taking slot formed of a positive plate and a negative plate in a matched mode, the LED lamp bead made of this support has the beneficial effects as mentioned above. For the LED module of the present invention, as a metal welding layer is provided on the bottom surface and the junction surface of the heat sink and the lamp bead is plated with a second metal welding layer, it is just required to directly weld the heat sink and the lamp bead together by tin paste during the assembling. Hence, the process is simple. Meanwhile, when assembling the driving circuit board of the LED module with the LED lamp bead, the power supply terminal of the LED driving board is directly snapped into the power-taking slot of the LED lamp bead, resulting in simple assembly, high efficiency and stable quality.

### BRIEF DESCRIPTION OF THE DRAWINGS

The present invention will be described reference to the accompanying drawings. Embodiments mentioned in the drawings do not form any limitation to the present invention. It is possible for one of ordinary skill in the art to obtain other drawings according to the following drawings without any creative efforts.
Fig. 1 is a structure diagram of the background of the present invention;
Fig. 2 is an exploded view of embodiment 1 of the present invention;
Fig. 3 is a structure diagram of a lamp bead according to embodiment 1 of the present invention;
Fig. 4 is a diagram of a conductive plate in progress according to embodiment 1 of the present invention; and
Fig. 5 is a structure diagram of a driving circuit board according to embodiment 2 of the present invention.

### DETAILED DESCRIPTION OF THE PREFERRED EMBODIEMTNS

The present invention will be further described by the following embodiments.

### Embodiment 1

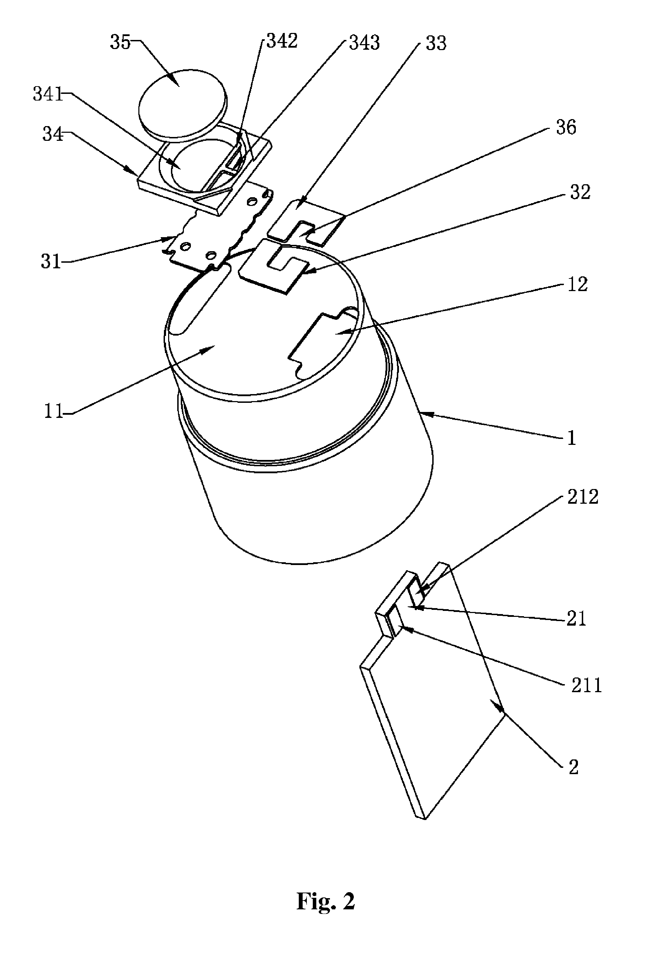

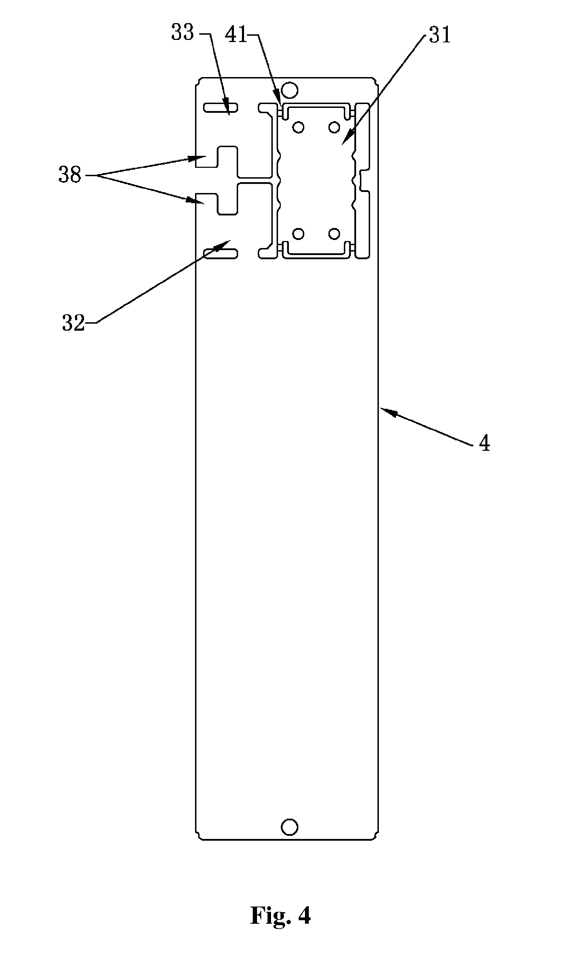

An easily-assembled LED module, as shown in Fig.2 to Fig.5, includes a columnar heat sink 1 (it may also be a heat sink 1 of a sunflower structure or other structures). One end of the heat sink 1 is open, while the other end thereof is a lamp bead 3 setting surface 11 for allowing a lamp bead 3 arranged thereon. The lamp bead 3 arrangement surface 11 is plated with a nickel layer (not shown). An inner cavity, having a driving circuit board 2 accommodated therein, is formed in the heat sink 1. One end of the driving circuit board 2 is provided with a power supply terminal to form a conductive region 21. The power supply terminal includes a positive terminal 211 and a negative terminal 212. In this embodiment, the size of the conductive region 21 of the driving circuit board 2 is smaller than that of other parts of the circuit board, so that only the conductive region 21 of the driving circuit board 2 can pass through a through hole 12 on the lamp bead 3 arrangement surface 11 of the heat sink 1. As shown in Fig. 4, the lamp bead 3 on the lamp bead 3 arrangement surface 11 of the heat sink 1 includes a support, a lamp cup 34 and packaging glue 35. The bottom surface of the support is plated with a nickel layer, while a silver layer is plated on the surface of the nickel layer. Both the nickel layer and the silver layer are metal welding layers. When it is required to fix the lamp bead 3 onto the heat sink 1, the welding fixation between the lamp bead 3 and the heat sink 1 may be realized by tin paste or other solders.

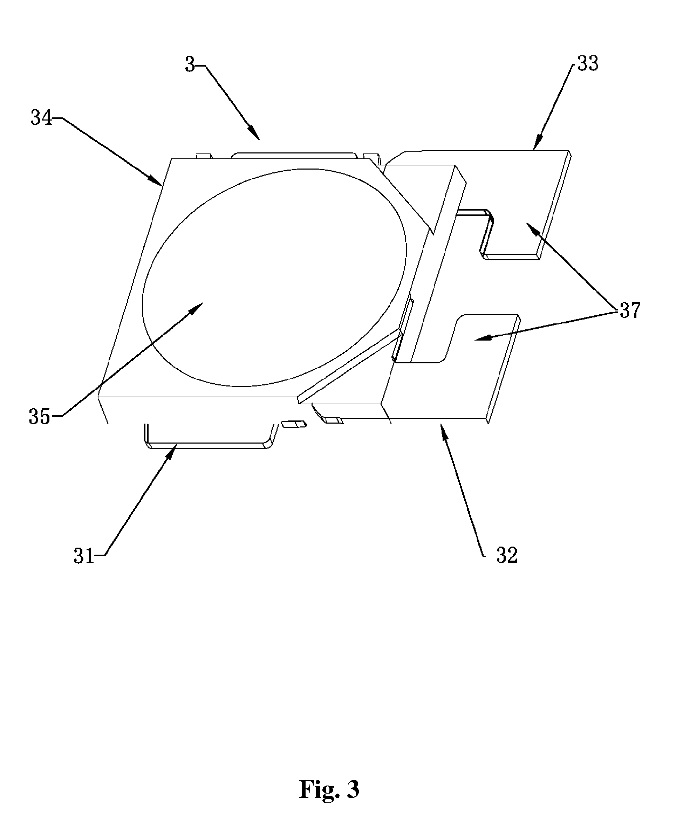

Specifically, as shown in Fig. 3, the support includes a substrate 31 and a power-taking plate consisting of a positive plate 32 and a negative plate 33. The substrate 31, the positive plate 32 and the negative plate 33 are fixedly connected to the lamp cup 34, respectively, so that the relative positions of the substrate 31, the positive plate 32 and the negative plate 33 are fixed, wherein the lamp cup 34 includes a cup cavity 341 to which the substrate 31 is exposed to form a wafer fixing region, a plurality LED wafers (not shown) are arranged on the wafer fixing region, and the LED wafers (or the LED wafers and the substrate 31, or the LED wafers and the power-taking plate) are conductively connected by bonding wires. Specifically, fixing the LED onto the substrate 31 may be realized by the conventional methods in the art and will not be repeatedly described here. As shown, both the positive plate 32 and the negative plate 33 are of a U-shaped structure. A portion of each of the positive plate and the negative plate partially in the cup cavity 341 is exposed to form a power supply region 38 for supplying power to the LED wafers, respectively, and the other portion thereof is embedded in the lamp cup 34 to allow the positive plate 32 and the negative plate 33 to be fixed by the lamp cup 34. The later portion is a fixing region of the positive plate 32 and the negative plate 33. More importantly, both the positive plate 32 and the negative plate 33 have portions exposed outside the lamp cup 34 to form a power-taking region 37 for directly taking power from the driving circuit board 2. The power-taking region 37 of the positive plate 32 and power-taking region 37 of the negative plate 33 are matched with each other to form a power-taking slot 36. The power-taking slot is used for allowing the conductive region 21 of the driving circuit board 2 to inert therein. The conductive region 21 is arranged to be in interference fit with the power-taking slot 36. When the conductive region 21 is inserted into the power-taking slot 36, the positive terminal 211 of the driving circuit board 2 will be connected to the positive plate 32, and the negative terminal 21 will be connected to the negative plate 33, so that an ON loop is formed between the power-taking plate and the driving circuit board 2.

In conclusion, the LED module is very easy to assemble. The assembling may be completed, by coating tin paste or other solders onto the heat sink 1, then welding the LED lamp bead 3 onto the heat sink 1, and inserting the driving circuit board 2 from the opening at the lower end of the heat sink 1 to allow the conductive region 21 thereof to pass through the through hole 12 of the lamp bead 3 arrangement surface 11 of the heat sin 1 until the conductive region 21 is inserted into the power-taking hole 36. The LED module is simple in assembling and advantageous for automation, and can effectively improve the efficiency and quality of assembling.

It is to be noted that:
(1) The reason why a nickel layer and a silver layer in this embodiment are plated on the rear surface of the support as metal welding layers is mainly that the silver layer and the nickel layer can provide corresponding protection for the lamp bead 3. According to actual needs, it is also possible to plate only one of the nickel layer and the silver layer on the rear surface of the support, as long as the thickness is properly increased. Further, for those skilled in the art, either the nickel layer on the heat sink 1 or the nickel layer and the silver layer on the rear surface of the support may be replaced by other metal materials beneficial to welding, and such metal materials will not be described here.
(2) The case where "the power-taking region 37 of the positive plate 32 and power-taking region 37 of the negative plate 33 are matched with each other to form a power-taking slot 36" described herein includes a case where the power-taking region 37 of the positive plate 32 and power-taking region 37 of the negative plate 33 are matched with each other or matched with other parts of the lamp bead 3 to form a power-taking slot 36, for example, a case where the power-taking region 37 of the positive plate 32, power-taking region 37 of the negative plate 33 and the outer wall of the lamp cup 34 together form a power-taking slot 36.
(3) The support in this embodiment is formed by directly punching copper material. Of course, it is also possible to form the support from other materials (as stated in the background art), for example, insulating material, as required, as long as a conductive film is plated on the surface of the support to provide for the electrical conductivity.
(4) Although both the positive plate 32 and the negative plate 33 in this embodiment are of a U-shaped structure, for those skilled in the art, structures in other shapes such as an L-shape may be possible, as required, as long as the positive plate 32 and the negative plate 33 are allowed to form the power supply region 38 in the cup cavity 341, form the power-taking region 327 outside the lamp cup 34 and form the power-taking slot 36 in a matched manner.

In addition, as shown in Fig. 3, a first spacer 342 for isolating the substrate 31 from the power-taking plate and a second spacer 343 for isolating the positive plate 32 from the negative plate 33 are provided in the cup cavity 341 of the lamp cap 34. The first spacer 342 and the second spacer 343 may effectively improve the safety performance between the substrate 31 and the power-taking plate, as well as between the positive plate 32 and the negative plate 33, for example, the creep distance between the substrate 31 and the power-taking plate and the insulating performance between the positive plate 32 and the negative plate 33.

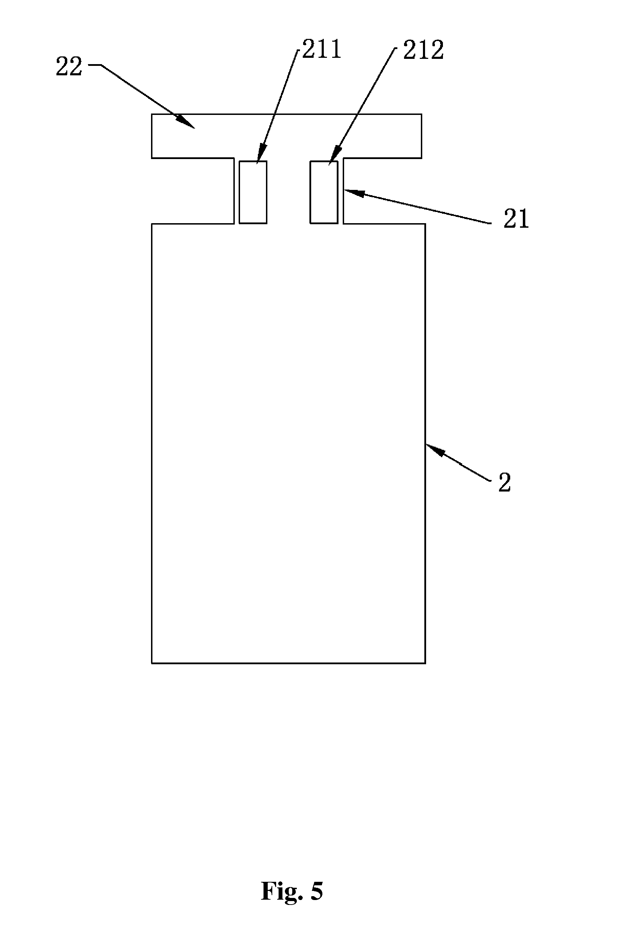

Specifically, the method for manufacturing the lamp bead 3, including the following steps:
a plate making step: as shown in Fig. 5, punching a conductive plate 4 to form a support, the support including a substrate 31, a positive plate 32 and a negative plate 33, the substrate 31, the positive plate 32 and the negative plate 33 being connected to the plate by connecting bars 41, respectively;
a injection molding step: injection-molding a lamp cup 34 on the plate with the support punched thereon;
a wafer fixing step: fixing LED wafers in the wafer fixing region of the substrate 31, and conductively connecting the substrate 31 to the positive plate 32 and the negative plate 33, respectively;
a glue filling step: filling packaging glue 35 in the cup cavity 341 to form a lamp bead 3; and
a separation step: cutting off the connecting bars 41 between the substrate 31, the positive plate 32 and the negative plate 33, and the plate, to allow the lamp bead 3 to separate from the plate.

### Embodiment 2

Another implementation of an easily-assembled LED module is provided here. The main technical solution of this embodiment is the same as embodiment 1, and the features not explained in this embodiment refer to those of embodiment 1 and will not be repeatedly described herein. This embodiment differs from embodiment 1 in that, as shown in Fig. 5, the length of the conductive region 21 is equal to the depth of the power-taking slot 36, one end of the conductive region 21 being a driving circuit board 2 body having a size larger than that of the power-taking slot, while the other end thereof being connected to a fixing portion 22 having a size larger than that of the power-taking slot 36. That is, a fixing portion 22 is further provided at the upper end of the conductive region 21, and the fixing portion 22 may be separately connected to the conductive region 21. When in assembling, the driving circuit board 2 is inserted in position and the fixing portion 22 is fixedly connected to the conductive region 21, so that the driving circuit board 2, the lamp bead 3 and the heat sink 1 are joined more firmly. Of course, the fixing portion 22 may also be integrated with the driving circuit board 2. In this case, for assembling, the through hole 12 and the power-taking slot 36 may be differently sized in different directions, so that the fixing portion 22 is inserted along the larger size direction of the through hole 12 and the power-taking slot 36 and then rotated by a certain angle to be snapped in the smaller size direction.

It should be noted that, the above embodiments are merely provided to describe the technical solutions of the present invention, instead of limiting the protection scope of the present invention. Although the present invention has been described in details by preferred embodiments, it should be understood that modifications or equivalent replacements may be made by one of ordinary skill in the art without departing from the spirit and scope of the technical solutions of the present invention.

## Claims

1. A support for an easily-assembled Chip on Board (COB) lamp bead, comprising a substrate (31) and a power-taking plate for supplying power to the substrate (31), wherein one surface of the substrate is plated with a first metal welding layer to form a welding surface, the power-taking plate comprising a positive plate (32) and a negative plate (33), which are electrically conductive, the positive plate and the negative plate being insulated from and matched with each other to form a power-taking slot (36).

2. The support for an easily-assembled COB lamp bead according to claim 1, wherein the support is obtained by punching a conductive plate.

3. An easily-assembled Chip on Board (COB) lamp bead, comprising a support onto which LED wafers are adhered on its front surface, wherein the bottom surface of the support is plated with a first metal welding layer, the support comprising a substrate (31) and a power-taking plate for supplying power to the LED wafers, the power-taking plate comprising a positive plate (32) and a negative plate (33), which are electrically conductive, the positive plate and the negative plate being insulated from and matched with each other to form a power-taking slot (36).

4. The easily-assembled COB lamp bead according to claim 3, wherein a lamp cup (34) is formed on the front surface of the support, the lamp cup comprising a cup cavity (341) to which the substrate is exposed to form a wafer fixing region for fixing the LED wafers; and each of the positive plate (32) and the negative plate (33) comprises a power supply region (38), a fixing region and a power taking region (37), the power supply region being exposed to the cup cavity (341), the fixing region is embedded on a wide wall of the lamp cup, the power taking region (37) being exposed outside the lamp cup (34) and forming the power-taking slot (36).

5. The easily-assembled COB lamp bead according to claim 4, wherein a first spacer (342) for isolating the substrate (31) from the power-taking plate is provided in the cup cavity (341).

6. The easily-assembled COB lamp bead according to claim 4 or 5, wherein a second spacer (343) for isolating the positive plate (32) from the negative plate (33) is provided in the cup cavity (341).

7. The easily-assembled COB lamp bead according to any of claims 3 to 6, wherein the first metal welding layer comprises a nickel layer covering the bottom surface of the support and a silver layer covering the nickel layer.

8. An easily-assembled LED module, comprising a heat sink (1), a lamp bead (3) fixed in the heat sink and a driving circuit board (2) for supplying current to the lamp bead, wherein the lamp bead (3) is the easily-assembled lamp bead according to any one of claims 3-7; a junction surface of the heat sink (1) with the lamp bead (3) is plated with a second metal welding layer, the first metal welding layer and the second metal welding layer being fixed with each other by welding; and a power supply terminal is provided at one end portion of the driving circuit board (2), the power supply terminal being snapped in the power-taking slot (36) to supply power to the power-taking plate.

9. The easily-assembled LED module according to claim 8, wherein an inner cavity is formed in the heat sink (1), the driving circuit board (2) being disposed in the inner cavity; a welding surface of the heat sink and the lamp bead is provided with a through hole (12); a conductive region (21), in which the conductive terminal is to be provided, of the driving circuit board is in interference fit with the conductive slot (36), the length of the conductive region (21) being equal to the depth of the power-taking slot (36), one end of the conductive region (21) being connected to a driving circuit board body having a size larger than that of the power-taking slot, while the other end thereof being connected to a fixing portion (22) having a size larger than that of the power-taking slot (36).

10. A method for manufacturing an easily-assembled Chip on Board (COB) lamp bead, comprising the following steps of: a plate making step, an injection molding step, a wafer fixing step, a glue filling step and a separation step, wherein:
the plate making step: punching a conductive plate to form a support, the support comprising a substrate, a positive plate and a negative plate, the substrate, the positive plate and the negative plate being connected to the plate by connecting bars, respectively;
the injection molding step: injection-molding a lamp cup on the plate with the support punched thereon, the lamp cup comprising a cup cavity, the cup cavity and the substrate forming a wafer fixing region, the cup cavity, the positive plate and the negative plate forming a power supply region;
the wafer fixing step: fixing LED wafers in the wafer fixing region of the substrate, and conductively connecting the substrate to the positive plate and the negative plate, respectively;
the glue filling step: filling packaging glue in the cup cavity to form a lamp bead; and
the separation step: cutting off the connecting bars between the substrate, the positive plate and the negative plate, and the plate, to allow the lamp bead to separate from the plate.
